(19) Europäisches Patentamt
European Patent Office
Office européen des brevets

(11) **EP 2 742 595 B1**

(12) **EUROPÄISCHE PATENTSCHRIFT**

(45) Veröffentlichungstag und Bekanntmachung des Hinweises auf die Patenterteilung:
**03.10.2018 Patentblatt 2018/40**

(21) Anmeldenummer: **12753426.1**

(22) Anmeldetag: **07.08.2012**

(51) Int Cl.:
**H03M 3/00** *(2006.01)*　　　**H02M 5/45** *(2006.01)*

(86) Internationale Anmeldenummer:
**PCT/EP2012/065471**

(87) Internationale Veröffentlichungsnummer:
**WO 2013/020987 (14.02.2013 Gazette 2013/07)**

(54) **VERFAHREN ZUM ERZEUGEN EINES DIGITALEN SIGNALS**

METHOD FOR GENERATING A DIGITAL SIGNAL

PROCÉDÉ POUR GÉNÉRER UN SIGNAL NUMÉRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.08.2011 DE 102011080586**

(43) Veröffentlichungstag der Anmeldung:
**18.06.2014 Patentblatt 2014/25**

(73) Patentinhaber: **Lenze Automation GmbH
31855 Aerzen (DE)**

(72) Erfinder:
• **DÜSTERBERG, Dirk
31860 Emmerthal (DE)**
• **BORCHERDING, Holger
31840 Hessisch Oldendorf (DE)**

(74) Vertreter: **Patentanwälte
Ruff, Wilhelm, Beier, Dauster & Partner mbB
Kronenstraße 30
70174 Stuttgart (DE)**

(56) Entgegenhaltungen:
**US-A- 4 972 436　　　US-A- 5 940 019
US-A1- 2007 108 953**

**Beschreibung**

Die Erfindung betrifft ein Verfahren zum Erzeugen eines digitalen Signals aus einem mittels eines Frequenzumrichters erzeugten analogen Signal und einen Frequenzumrichter zur Durchführung des Verfahrens.

Frequenzumrichter erzeugen zur Ansteuerung von Elektromotoren typisch pulsweitenmodulierte Signale, beispielsweise in Form einer (Phasen-)Spannung, wobei die Phasenspannung wiederum einen Phasenstrom bewirkt. Bei Frequenzumrichtern, die den Phasenstrom im Kontext einer Regelung zurückführen, ist die Qualität der Signalmessung bzw. Signalrückführung von hoher Bedeutung.

Die zu messenden Signale werden hierzu üblicherweise mittels geeigneter Sensoren aufgenommen, analog gefiltert und anschließend mittels herkömmlicher Analog-Digital-Wandler abgetastet und digitalisiert.

Der im Allgemeinen sägezahnförmige Phasenstrom als eines der relevanten Signale wird üblicherweise synchron in der Mitte einer jeweiligen Periode der Pulsweitenmodulation abgetastet. Bei nicht exakt mittiger Abtastung kann jedoch ein Offset-Messfehler verursacht werden.

Durch Mittelwertbildung über eine Periodendauer der Pulsweitenmodulation lassen sich die oben genannten Störeffekte reduzieren. Zur Mittelwertbildung wird herkömmlich eine Mehrzahl von digitalen Messwerten über eine Periodendauer der Pulsweitenmodulation gewonnen und anschließend ein Mittelwert über die gewonnenen Messwerte berechnet. Ein Verfahren, bei dem eine solche Mittelwertbildung durchgeführt wird, ist in der DE 10 2007 032 484 A1 beschrieben.

Die US 2007/0108953 A1 offenbart ein Schaltnetzteil mit einer Regelungsschaltung, die einen A/D-Wandler zur Digitalisierung des analogen Ausgangssignals des Schaltnetzteils umfasst.

Die US 5,940,019 A zeigt einen A/D-Wandler mit einem Delta-Sigma-Modulator, dessen Ausgangsbitstrom mit einem Datenwandlungswert multipliziert wird, wobei der Datenwandlungswert eine Verstärkung bestimmt. Die derart gewonnenen Werte werden anschließend mittels eines Dezimierungsfilters datenratenreduziert, um ein digitales Ausgangssignal zu erzeugen.

Der Erfindung liegt die Aufgabe zugrunde, ein Verfahren zum Erzeugen eines digitalen Signals aus einem mittels eines Frequenzumrichters auf Basis einer Pulsweitenmodulation erzeugten analogen Signal und einen Frequenzumrichter zur Durchführung des Verfahrens zur Verfügung zu stellen, die einfach und kostengünstig zu implementieren sind und die insbesondere eine störsichere und zuverlässige Digitalisierung ermöglichen.

Die Erfindung löst diese Aufgabe durch ein Verfahren nach Anspruch 1 und einen Frequenzumrichter nach Anspruch 5.

Bevorzugte Ausführungsformen sind Gegenstand der Unteransprüche, deren Wortlaut hiermit durch Bezugnahme zum Inhalt der Beschreibung gemacht wird.

Das Verfahren dient zum Erzeugen mindestens eines digitalen bzw. digitalisierten Signals aus einem mittels eines Frequenzumrichters auf Basis einer Pulsweitenmodulation erzeugten analogen Signal, beispielsweise eines Phasenstroms und/oder einer Phasenspannung, das zur Ansteuerung eines Elektromotors dient, wobei das digitale Signal, insbesondere in digitaler Darstellung, einem Mittelwert des analogen Signals über eine Periodendauer der Pulsweitenmodulation entspricht. Das digitale Signal dient insbesondere zur Regelung des analogen Signals, beispielsweise in einem Servo-Umrichter. Bei dem Verfahren wird ein fortlaufender Bitstrom mit einer vorgegebenen, insbesondere konstanten, Bitwiederholdauer in Abhängigkeit von dem analogen Signal erzeugt, insbesondere mittels eines Sigma-Delta-Modulators. Während eines jeweiligen Zeitintervalls, welches eine Dauer aufweist, die mindestens so groß ist wie die Periodendauer der Pulsweitenmodulation, werden folgende Schritte durchgeführt: Multiplizieren eines jeweiligen Bits des Bitstroms mit einem zugehörigen Bewertungskoeffizienten zum Erzeugen eines jeweiligen Bit-Bewertungskoeffizienten-Produkts und Summieren sämtlicher Bit-Bewertungskoeffizienten-Produkte über das Zeitintervall, wobei die Summe über das Zeitintervall das digitale Signal darstellt. Die oben genannten Schritte werden fortlaufend wiederholt, beispielsweise für jede Periode oder jede n-te Periode der Pulsweitenmodulation, mit $n \geq 2$.

Unter einer digitalen Darstellung eines Signals bzw. einem digitalen Signal wird eine Folge von zeit- und amplitudendiskret digitalisierten Abtastwerten verstanden, die einerseits einen abgegrenzten und gestuften Wertvorrat aufweisen und zudem in der zeitlichen Abfolge nur zu bestimmten periodischen Zeitpunkten definiert sind bzw. eine Veränderung im Abtastwert zeigen. Das Signal in digitaler Darstellung wird aus einem zugehörigen analogen Signal, welches den zeitlich kontinuierlichen Verlauf einer physikalischen Größe beschreibt, durch Quantisierung und Abtastung, welche zu definierten Zeitpunkten erfolgt, gebildet. Durch eine entsprechende Codierung kann ein Digitalsignal in eine binäre Darstellung übergeführt werden. Im Übrigen sei auch auf die umfangreiche Fachliteratur verwiesen.

Die Bewertungskoeffizienten werden durch Überlagern von Gewichtungskoeffizienten einer Gewichtungsfunktion erzeugt, wobei ein Mittelpunkt einer jeweiligen Gewichtungsfunktion innerhalb einer Periode der Pulsweitenmodulation liegt, eine jeweilige Gewichtungsfunktion einer digitalen Filterfunktion entspricht, benachbarte

Gewichtungsfunktionen zeitlich um eine oder eine Vielfache der Bitwiederholdauer zueinander verschoben sind und eine jeweilige Gewichtsfunktion eine vorgegebene Anzahl von Gewichtungskoeffizienten aufweist. Bevorzugt weist das Zeitintervall eine Dauer auf, die um eine Anzahl von Bitwiederholdauern länger ist als eine Periodendauer der Pulsweitenmodulation, wobei die Anzahl von Bitwiederholdauern der Anzahl von Gewichtungskoeffizienten entspricht.

In einer Weiterbildung ist das Zeitintervall zentrisch zu einer Periode der Pulsweitenmodulation angeordnet.

In einer Weiterbildung ist die digitale Filterfunktion eine sinc-Filterfunktion.

Der Frequenzumrichter, insbesondere in Form eines Servo-Umrichters, ist zur Durchführung des oben genannten Verfahrens ausgebildet und weist auf: einen Sigma-Delta-Modulator zum Erzeugen des Bitstroms, einen Speicher, der die Gewichtungskoeffizienten speichert, einen Multiplizierer, der dazu ausgebildet ist, ein jeweiliges Bit des Bitstroms mit einem zugehörigen Gewichtungskoeffizienten zu multiplizieren, und einen Summierer, der dazu ausgebildet ist, die jeweiligen Bit-Bewertungskoeffizienten-Produkte zu summieren.

Die Erfindung wird nachfolgend unter Bezugnahme auf die Zeichnungen beschrieben, die bevorzugte Ausführungsformen der Erfindung darstellen. Hierbei zeigt schematisch:

Fig. 1    mittels eines Frequenzumrichters auf Basis einer Pulsweitenmodulation erzeugte bzw. bewirkte analoge Signale in Form einer Phasenspannung und eines Phasenstroms,

Fig. 2    ein Blockschaltbild einer Schaltung zum Erzeugen eines digitalen Signals aus den in Fig. 1 gezeigten Signalen,

Fig. 3    eine Gewichtungsfunktion eines digitalen sinc[3]-Filters mit insgesamt 384 Gewichtungskoeffizienten und

Fig. 4    eine Mehrzahl von benachbarten Gewichtungsfunktionen, die zeitlich um eine Anzahl von Bitwiederholdauern eines SigmaDelta-Modulators zueinander verschoben sind, und Bewertungskoeffizienten, die durch Überlagern von Gewichtungskoeffizienten einer bestimmten Anzahl von benachbarten Gewichtungsfunktionen erzeugt sind.

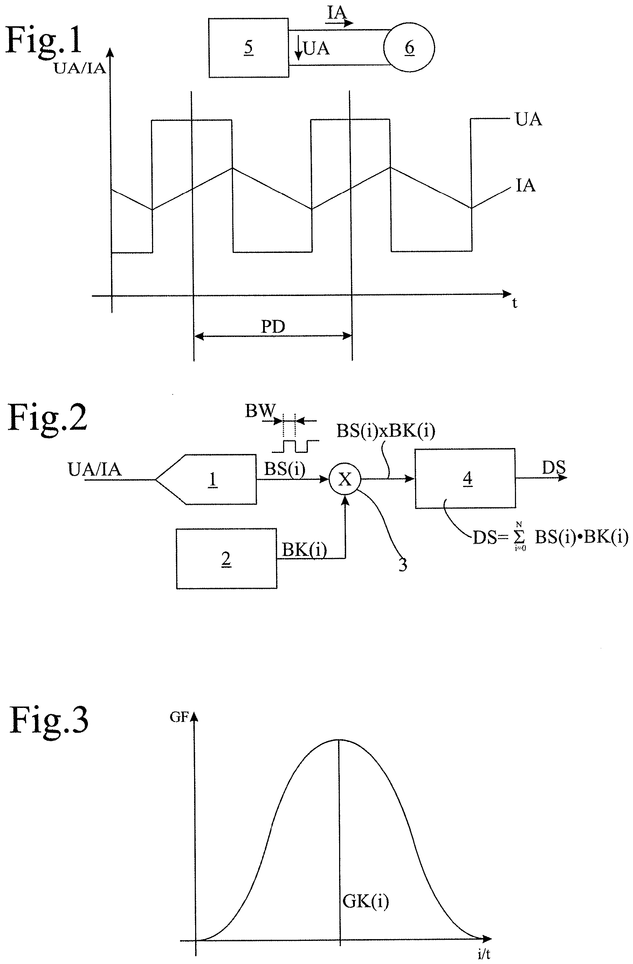

Fig. 1 zeigt herkömmlich mittels eines Frequenzumrichters 5 auf Basis einer Pulsweitenmodulation erzeugte bzw. bewirkte analoge Signale in Form einer im Wesentlichen rechteckförmigen, pulsweitenmodulierten Phasenspannung UA mit einem veränderlichen Tastverhältnis und eines zugehörigen, sagezahnförmigen Phasenstroms IA, wie sie bei einer herkömmlichen, pulsweitenmodulationsbasierten Ansteuerung eines Elektromotors 6 durch den Frequenzumrichter 5 entstehen. Zur Regelung der Signale UA und/oder IA werden diese erfindungsgemäß fortlaufend zeit- und amplitudendiskret digitalisiert, wobei das digitale bzw. digitalisierte Signal einem Mittelwert des analogen Signals UA bzw. IA über eine Periodendauer PD der Pulsweitenmodulation entspricht. Eine Periodendauer kann beispielsweise ca. 0,25 ms betragen und bedarfsabhängig verändert werden.

Zunächst bezugnehmend auf Fig. 2 wird hierzu ein fortlaufender Bitstrom BS(i), mit i = 0, 1, 2, ..., mit einer vorgegebenen Bitwiederholdauer BW in Abhängigkeit von dem analogen Signal UA bzw. IA mittels eines Sigma-Delta-Modulators 1 erzeugt. Die Bitwiederholdauer BW kann beispielsweise 0,25 μs betragen, was einer Bitwiederholfrequenz von 4 MHz entspricht.

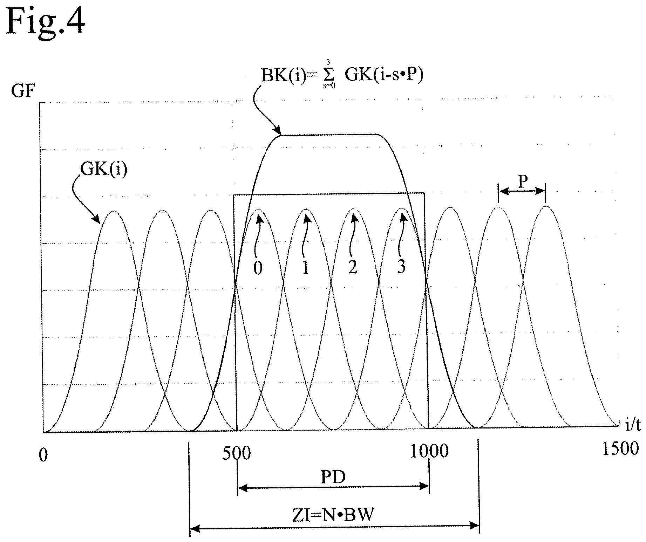

Während eines Zeitintervalls ZI (siehe Fig. 4), welches eine Dauer aufweist, die mindestens so groß ist wie die Periodendauer PD der Pulsweitenmodulation, werden alle Bits BS(i) des Bitstroms mit einem zugehörigen, in einem Speicher 2 abgelegten Bewertungskoeffizienten BK(i) zum Erzeugen eines jeweiligen Bit-Bewertungskoeffizienten-Produkts mittels eines Multiplizierers 3 multipliziert. Die derart erzeugten Bit-Bewertungskoeffizienten-Produkte werden mittels eines Summierers 4 aufsummiert, wobei die Summe über das Zeitintervall ZI das digitale Signal DS darstellt.

Die oben genannten Schritte können für nachfolgende Perioden oder für jede n-te Periode entsprechend wiederholt werden, wobei die Laufvariable i hierzu wieder zu Null gesetzt werden kann. Falls ein digitalisierter Messwert für jede Periode erzeugt werden soll, kann die in Fig. 2 gezeigte Schaltung dupliziert werden, wobei die beiden Schaltungen zeitlich versetzt, d.h. interleaved, arbeiten.

Anhand der Figuren 3 und 4 wird nachfolgend beschrieben, wie die Bewertungskoeffizienten BK(i) berechnet werden. Einem einzelnen Inkrement der Laufvariablen i entspricht hierbei die Bitwiederholdauer BW im Zeitbereich.

Fig. 3 zeigt eine Gewichtungsfunktion GF eines herkömmlichen digitalen sinc[3]-Filters mit einem Oversampling-Ratio von 128 mit insgesamt 384 Gewichtungskoeffizienten GK(i). Derartige Filter werden herkömmlich am Ausgang von Sigma-Delta-Modulatoren zur Datenratenreduktion verwendet.

Fig. 4 zeigt basierend auf der in Fig. 3 dargestellten, einzelnen Gewichtungsfunktion GF eine Mehrzahl von benachbarten Gewichtungsfunktionen GF, die um P Schritte zueinander verschoben sind. Ein einzelner Schritt entspricht hierbei der Bitwiederholdauer BW des Sigma-Delta-Modulators 1, wie oben bereits ausgeführt, so dass die Gewichtungsfunktionen GF im Zeitbereich bzw. über der Zeit um P Bitwiederholdauern BW zueinander verschoben sind.

Die Periodendauer der Pulsweitenmodulation beträgt in Fig. 4 exemplarisch 500 * BW und das Zeitintervall ZI, d.h. das Integrationsintervall, (500 + 384/2 + 384/2) * BW = N * BW. Das Zeitintervall ZI weist folglich eine Dauer auf, die um die Anzahl von Gewichtungskoeffizienten des in Fig. 2 gezeigten sinc[3]-Filters multipliziert mit der Bitwiederholdauer BW länger ist als die Periodendauer PD der Pulsweitenmodulation.

Das Zeitintervall ZI ist zentrisch zu der Periode der Pulsweitenmodulation angeordnet.

Die Bewertungskoeffizienten BK(i) werden nun durch Überlagern der Gewichtungskoeffizienten GK(i) derjenigen Gewichtungsfunktion GF erzeugt, deren Mittelpunkt innerhalb der Periode der Pulsweitenmodulation liegt. Es sind dies die mit den Ziffern 0 bis 3 markierten Gewichtungsfunktionen.

Die Bewertungskoeffizienten BK(i) können wie folgt dargestellt werden:

$$BK(i) = \sum_{s=0}^{s=3} GK(i - s \cdot P)$$

Das digitale Signal DS ergibt sich schließlich zu:

$$DS = \sum_{i=0}^{N} BS(i) \cdot BK(i)$$

Bei dem in der DE 10 2007 032 484 A1 beschrieben Verfahren wird der Mittelwert über eine Mehrzahl von vollständig digitalisierten Abtastwerten bzw. Samples innerhalb der Periode gebildet. Hierzu ist entsprechend parallelisierte Hardware vorzusehen, die diese Samples mit geeignet dezimierter Abtastrate mit der erforderlichen zeitlichen Auflösung und Wortbreite bereitstellt.

Anstelle des Integrals der dezimierten Samples wird erfindungsgemäß das Integral der Bewertungs- bzw. Gewichtungsfunktion zugehöriger Dezimierungsfilter verwendet, wobei die hierzu erforderlichen Koeffizienten vorausberechnet und in einem Speicher abgelegt werden.

Dies macht es möglich, auf das in herkömmlichen Implementierungen mit Sigma-Delta-Modulatoren erforderliche Dezimierungsfilter zu verzichten, so dass aufgrund der Einsparung von entsprechenden Logikelementen eine kostengünstigere und energiesparendere Implementierung möglich ist.

Weiter ist es möglich, die Bitwiederholfrequenz des Sigma-Delta-Modulators direkt ohne vorige Reduktion zu verwenden.

Die integrierte Bewertungsfunktion hat weiter die Eigenschaft, im mittleren Bereich flach zu sein, siehe Fig. 4. Diese Eigenschaft lässt sich beispielsweise dazu nutzen, den Speicherbedarf für die Koeffizienten zu minimieren, da nur die steigende und die fallende Flanke zu speichern sind.

Weiter erleichtert diese Eigenschaft die Anpassung an eine veränderliche Periodendauer. Bei einer Veränderung der Periodendauer der pulsweitenmodulierten Signale ist eine einfache Anpassung des erfindungsgemäßen Verfahrens beispielsweise dadurch möglich, dass die Koeffizienten GK(i) entsprechend angepasst werden. Wenn beispielsweise basierend auf der Darstellung in Fig. 4 die Periodendauer PD verlängert wird, verlängert sich lediglich die Dauer des Plateaus mit konstanten Koeffizienten BK(i), die Flanken bleiben unverändert.

Bei den gezeigten Ausführungsformen erfolgt eine Überlagerung bzw. Integration der Gewichtungs- bzw. Bewertungsfunktion, nicht wie herkömmlich der bereits dezimierten Samples. Die Anwendung der überlagerten Gewichtungsfunktionen erfolgt aus einem Speicher. Eine exakte Anpassung der überlagerten Gewichtungsfunktion an die Periodendauer der Pulsweitenmodulation ist einfach möglich. Als Gewichtungsfunktionen sind nahezu beliebige Funktionen verwendbar, so dass eine Vielzahl von zugehörigen Filterfunktionen einsetzbar ist.

Die exakte Integration über eine Periode erhöht die Messgenauigkeit, wodurch eine Phasenspannungsmessung erst vernünftig möglich wird.

Es sind keine Sinc-Filter mehr notwendig, so dass deutlich weniger Hardware-Ressourcen verbraucht werden.

Die Bewertungskoeffizienten lassen sich für Spannung und Strom gleichzeitig nutzen.

Hieraus ergibt sich eine Vielzahl von Anwendungsmöglichkeiten, wie beispielsweise eine Wechselrichterfehlerkompensation, eine Spannungsregelung und eine sensorlose Regelung bis Drehzahl Null.

Die Erfindung ermöglicht folglich eine einfach und kostengünstig zu implementierende Digitalisierung von Umrichtersignalen, wobei gleichzeitig eine störsichere und zuverlässige Digitalisierung sichergestellt ist.

**Patentansprüche**

1. Verfahren zum Erzeugen eines digitalen Signals (DS) aus einem mittels eines Frequenzumrichters auf Basis einer Pulsweitenmodulation erzeugten analogen Signal (IA, UA), wobei das digitale Signal einem Mittelwert des analogen Signals über eine Periodendauer (PD) der Pulsweitenmodulation entspricht, mit den Schritten

  - Erzeugen eines Bitstroms (BS(i)) mit einer vorgegebenen Bitwiederholdauer (BW) in Abhängigkeit von dem analogen Signal mittels eines Sigma-Delta-Modulators (1) und
  - während eines Zeitintervalls (ZI), welches eine Dauer aufweist, die mindestens so groß ist wie die Periodendauer der Pulsweitenmodulation:

    - Multiplizieren eines jeweiligen Bits (BS(i)) des Bitstroms mit einem zugehörigen Bewertungskoeffizienten (BK(i)) zum Erzeugen eines jeweiligen Bit-Bewertungskoeffizienten-Produkts, wobei die Bewertungskoeffizienten durch Überlagern von Gewichtungskoeffizienten (GK(i)) von Gewichtungsfunktionen (GF) erzeugt werden, wobei ein Mittelpunkt einer jeweiligen Gewichtungsfunktion innerhalb einer Periode der Pulsweitenmodulation liegt, eine jeweilige Gewichtungsfunktion einer digitalen Filterfunktion entspricht, benachbarte Gewichtungsfunktionen zeitlich um eine oder eine Vielfache der Bitwiederholdauer zueinander verschoben sind und eine jeweilige Gewichtsfunktion eine vorgegebene Anzahl von Gewichtungskoeffizienten aufweist, und

- Summieren der jeweiligen Bit-Bewertungskoeffizienten-Produkte, wobei die Summe das digitale Signal darstellt.

2. Verfahren nach Anspruch 1, **dadurch gekennzeichnet, dass** das Zeitintervall eine Dauer aufweist, die um eine Anzahl von Bitwiederholdauern länger ist als eine Periodendauer der Pulsweitenmodulation, wobei die Anzahl von Bitwiederholdauern der Anzahl von Gewichtungskoeffizienten entspricht.

3. Verfahren nach einem der vorhergehenden Ansprüche, **dadurch gekennzeichnet, dass** das Zeitintervall zentrisch zu einer Periode der Pulsweitenmodulation angeordnet ist.

4. Verfahren nach einem der vorhergehenden Ansprüche, **dadurch gekennzeichnet, dass** die digitale Filterfunktion eine sinc-Filterfunktion ist.

5. Frequenzumrichter zur Durchführung des Verfahrens nach einem der Ansprüche 1 bis 4, umfassend

- einen Sigma-Delta-Modulator (1) zum Erzeugen des Bitstroms,
- einen Speicher (2), der die Gewichtungskoeffizienten speichert,
- einen Multiplizierer (3), der dazu ausgebildet ist, ein jeweiliges Bit des Bitstroms mit einem zugehörigen Gewichtungskoeffizienten zu multiplizieren, und
- einen Summierer (4), der dazu ausgebildet ist, die jeweiligen Bit-Bewertungskoeffizienten-Produkte zu summieren.

**Claims**

1. Method for generating a digital signal (DS) from an analog signal (IA, UA) generated by means of a frequency converter on the basis of pulse width modulation, wherein the digital signal corresponds to a mean value of the analog signal over a period (PD) of the pulse width modulation, the method comprising the steps:

- generating a bit stream (BS)(i)) having a predetermined bit repetition duration (BW) in response to the analog signal by means of a sigma-delta modulator (1), and
- during a time interval (ZI) having a duration that is at least equal to the period of the pulse width modulation:

- multiplying a respective bit (BS(i)) of the bit stream by a corresponding rating coefficient (BK(i)) for generating a respective bit/rating coefficient product, wherein the rating coefficients are generated by superimposing weighting coefficients (GK(i)) of weighting functions (GF), wherein a midpoint of a respective weighting function is within a period of the pulse width modulation, a respective weighting function corresponds to a digital filter function, adjacent weighting functions are temporally shifted with respect to one another by one or a multiple of the bit repetition duration, and a respective weighting function has a predetermined number of weighting coefficients, and
- summing the respective bit/rating coefficient products, wherein the sum represents the digital signal.

2. Method according to claim 1, **characterized in that** the time interval has a duration which is longer than a period of the pulse width modulation by a number of bit repetition durations, wherein the number of bit repetition durations corresponds to the number of weighting coefficients.

3. Method according to any of the preceding claims, **characterized in that** the time interval is arranged centrally with respect to a period of the pulse width modulation.

4. Method according to any of the preceding claims, **characterized in that** the digital filter function is a sinc filter function.

5. Frequency converter for implementing the method according to any of claims 1 to 4, comprising

- a sigma-delta modulator (1) for generating the bit stream,
- a memory (2) which stores the weighting coefficients,
- a multiplier (3) which is adapted to multiply a respective bit of the bit stream by a corresponding weighting coefficient, and
- a summer (4) which is designed to sum the respective bit/rating coefficient products.

**Revendications**

1. Procédé pour générer un signal numérique (DS) à partir d'un signal analogique (IA, UA) généré au moyen d'un convertisseur de fréquence sur la base d'une modulation d'impulsions en largeur, le signal numérique correspondant à une valeur moyenne du signal analogique sur une durée de période (PD) de la modulation d'impulsions en largeur, comprenant les étapes suivantes

    - génération d'un train de bits (BS(i)) ayant une durée de répétition des bits (BW) prédéfinie en fonction du signal analogique au moyen d'un modulateur sigma-delta (1) et
    - pendant un intervalle de temps (ZI), dont la durée est au moins égale à la durée de période de la modulation d'impulsions en largeur :

        - multiplication d'un bit (BS(i)) respectif du train de bits par un coefficient d'évaluation (BK(i)) associé en vue de générer un produit bit par coefficient d'évaluation respectif, les coefficients d'évaluation étant générés par superposition de coefficients de pondération (GK(i)) de fonctions de pondération (GF), un point central d'une fonction de pondération respective se trouvant à l'intérieur d'une période de la modulation d'impulsions en largeur, une fonction de pondération respective correspondant à une fonction de filtrage numérique, des fonctions de pondération voisines étant décalées dans le temps les unes par rapport aux autres d'une durée de répétition des bits ou d'un multiple de celle-ci et une fonction de pondération respective possédant un nombre prédéfini de coefficients de pondération, et
        - addition des produits bit par coefficient d'évaluation respectifs, la somme représentant le signal numérique.

2. Procédé selon la revendication 1, **caractérisé en ce que** l'intervalle de temps possède une durée qui est plus longue d'un certain nombre de durées de répétition des bits qu'une durée de période de la modulation d'impulsions en largeur, le nombre de durées de répétition des bits correspondant au nombre de coefficients de pondération.

3. Procédé selon l'une des revendications précédentes, **caractérisé en ce que** l'intervalle de temps est disposé de manière centrée par rapport à une période de la modulation d'impulsions en largeur.

4. Procédé selon l'une des revendications précédentes, **caractérisé en ce que** la fonction de filtrage numérique est une fonction de filtrage sinc.

5. Convertisseur de fréquence destiné à mettre en oeuvre le procédé selon l'une des revendications 1 à 4, comportant

    - un modulateur sigma-delta (1) destiné à générer le train de bits,
    - une mémoire (2) qui enregistre les coefficients de pondération,
    - un multiplicateur (3) qui est configuré pour multiplier un bit respectif du train de bits par un coefficient de pondération associé, et
    - un additionneur (4) qui est configuré pour additionner les produits bit par coefficient d'évaluation respectifs.

Fig.1

Fig.2

$$DS = \sum_{i=0}^{N} BS(i) \cdot BK(i)$$

Fig.3

# Fig.4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007032484 A1
- US 20070108953 A1

- US 5940019 A